# EUROPEAN PATENT APPLICATION

(11) **EP 4 764 531 A1**
(43) Date of publication of application: **24.06.2026**
(21) Application number: 25749092.0
(22) Date of filing: 15.01.2025
(51) Int. Cl.: G01R 31/382, G01R 31/396, G01R 19/165, G01R 19/00

(54) **BATTERY DIAGNOSTIC DEVICE AND OPERATING METHOD THEREOF**

(30) Priority: 02.02.2024 KR 20240016646
(71) Applicant: LG Energy Solution, Ltd., Seoul 07335 (KR)
(72) Inventor: CHOI, Jee Soon, Daejeon 34122 (KR); KIM, Young Jin, Daejeon 34122 (KR); KIM, Min Hwa, Daejeon 34122 (KR)
(74) Representative: Goddar, Heinz J.
(86) International application number: PCT/KR2025/000867
(87) International publication number: WO 2025/165005

(57) **Abstract**

A battery diagnostic device according to an embodiment disclosed herein may include an information acquisition unit configured to acquire voltages of a plurality of battery cells and a controller configured to calculate a capacity/voltage second-order differential value of the voltages of the plurality of battery cells and set at least a portion of a state of charge (SOC) section or at least a portion of a voltage section in which the second-order differential value is less than or equal to a first value as a diagnostic section.

## Description

### CROSS-REFERENCE TO RELATED APPLICATION

The present application claims the benefit of the priority of Korean Patent Application No. 10-2024-0016646, filed on February 2, 2024, which is hereby incorporated by reference in its entirety.

### TECHNICAL FIELD

Embodiments disclosed herein relate to a battery diagnostic device and a method of operating the same.

### BACKGROUND ART

In recent years, research and development for secondary batteries have been actively conducted. Here, the secondary battery is a battery capable of recharging and discharging, and in its meaning, includes all of the existing Ni/Cd battery, Ni/MH battery, and the like and a recent lithium-ion battery. Among secondary batteries, the lithium-ion battery has the advantage of a much higher energy density than the existing Ni/Cd battery, Ni/MH battery, and the like. In addition, since the lithium-ion battery may be manufactured to be small and lightweight, the lithium-ion battery is used as a power source for mobile devices, and in recent years, its scope of use has expanded to include power sources for electric vehicles, so that the lithium-ion battery attracts attention as a next-generation energy storage medium.

A method of diagnosing a battery for tab breakage and lithium precipitation is essential for diagnosing the performance and abnormality of the battery. Although low-rate differential indices may diagnose capacity and precipitation based on laboratory data, there are limitations when applying field data. Since batteries with tab breakage and lithium precipitation pose a risk of performance degradation or fire, a method capable of diagnosing abnormality of the battery based on field data is required.

### DISCLOSURE OF THE INVENTION

### TECHNICAL PROBLEM

The embodiments disclosed herein are directed to providing a battery diagnostic device capable of immediately identifying an abnormal sign by applying a diagnostic technique utilizing second-order differentiation to field data and a method of operating the same.

The embodiments disclosed herein are also directed to providing a battery diagnostic device capable of diagnosing relative capacity deviation of cells in a battery pack by utilizing the second-order differentiation, rather than the first-order differentiation, of an open circuit voltage and a method of operating the same.

The technical problems of the embodiments disclosed herein are not limited to those mentioned above, and other objectives not mentioned will be clearly understood by those skilled in the art from the following descriptions.

### TECHNICAL SOLUTION

A battery diagnostic device according to an embodiment disclosed herein includes an information acquisition unit configured to acquire voltages of a plurality of battery cells and a controller configured to calculate a capacity/voltage second-order differential value of the voltages of the plurality of battery cells and set at least a portion of a state of charge (SOC) section or at least a portion of a voltage section in which the second-order differential value is less than or equal to a first value as a diagnostic section.

In an embodiment, the controller may diagnose the plurality of battery cells in the diagnostic section.

In an embodiment, the controller may calculate a partial capacity of each of the plurality of battery cells in the diagnostic section and diagnose the plurality of battery cells based on the calculated partial capacity of each of the plurality of battery cells.

In an embodiment, the controller may calculate the partial capacity of each of the plurality of battery cells through current accumulation.

In an embodiment, the controller may calculate a deviation of the partial capacity of each of the plurality of battery cells and diagnose a battery cell with a deviation equal to or greater than a second value as an abnormal battery cell.

In an embodiment, the controller may calculate the capacity/voltage second-order differential value for each of the plurality of battery cells and set at least a portion of the SOC section or at least a portion of the voltage section in which second-order differential values of all of the plurality of battery cells are less than or equal to the first value as the diagnostic section.

In an embodiment, the controller may calculate an average voltage of the plurality of battery cells, calculate a capacity/voltage second-order differential value with respect to the average voltage of the plurality of battery cells, and set at least a portion of the SOC section or at least a portion of the voltage section in which the capacity/voltage second-order differential value with respect to the average voltage of the plurality of battery cells is less than or equal to the first value as the diagnostic section.

In an embodiment, the voltages of the plurality of battery cells may be open circuit voltages of the plurality of battery cells.

A method of operating a battery diagnostic device according to an embodiment disclosed herein may include.

In an embodiment, the method may include acquiring voltages of a plurality of battery cells, calculating a capacity/voltage second-order differential value of the voltages of the plurality of battery cells, and setting at least a portion of a state of charge (SOC) section or at least a portion of a voltage section in which the second-order differential value is less than or equal to a first value as a diagnostic section.

In an embodiment, the method may further include diagnosing the plurality of battery cells in the diagnostic section.

In an embodiment, the method may further include calculating a partial capacity of each of the plurality of battery cells in the diagnostic section and diagnosing the plurality of battery cells based on the calculated partial capacity of each of the plurality of battery cells.

In an embodiment, in the calculating of the partial capacity of each of the plurality of battery cells in the diagnostic section, the partial capacity of each of the plurality of battery cells may be calculated through current accumulation.

In an embodiment, the diagnosing of the plurality of battery cells based on the calculated partial capacity of each of the plurality of battery cells may include calculating a deviation of the partial capacity of each of the plurality of battery cells and diagnosing a battery cell with a deviation equal to or greater than a second value as an abnormal battery cell.

### ADVANTAGEOUS EFFECTS

A battery diagnostic device and a method of operating the same according to an embodiment disclosed herein can diagnose partial capacity reduction and lithium precipitation of a battery cell based on a battery diagnostic technology utilizing second-order differentiation.

A battery diagnostic device and a method of operating the same according to an embodiment disclosed herein can diagnose a battery cell or a battery pack based on field data of a battery.

Besides, various effects may be provided that are directly or indirectly identified through the present disclosure.

### BRIEF DESCRIPTION OF THE DRAWINGS

FIG. 1 is a block diagram showing the configuration of a general battery pack.
FIG. 2 is a diagram showing a battery diagnostic device according to an embodiment disclosed herein.
FIGS. 3a and 3b are drawings showing examples of a battery diagnostic device setting a diagnostic section according to an embodiment disclosed herein.
FIG. 4 is a flowchart showing a method of operating a battery diagnostic device according to an embodiment disclosed herein.
FIGS. 5 and 6 are flowcharts specifically showing an operating method of a battery diagnostic device according to an embodiment disclosed herein.
FIG. 7 is a block diagram showing a hardware configuration of a computing system for performing a method of operating a battery diagnostic device according to an embodiment disclosed herein.

### MODE FOR CARRYING OUT THE INVENTION

Hereinafter, embodiments disclosed herein will be described in detail with reference to exemplary drawings. In adding reference numerals to the components of each drawing, it should be noted that the same components are given the same reference numerals as much as possible even though they are shown on different drawings. In addition, in describing the embodiments disclosed herein, when a detailed description of a related known configuration or function is determined to hinder understanding of the embodiments disclosed herein, the detailed description thereof is omitted.

In addition, in describing a component of the embodiments disclosed herein, terms such as first, second, A, B, (a), (b), etc. may be used. These terms are only for distinguishing the component from other components, and the essence, sequence, or order of the component is not limited by the terms. In addition, unless otherwise defined, all terms used herein, including technical or scientific terms, have the same meaning as commonly understood by those of ordinary skill in the art to which the embodiments disclosed herein belong. Terms, such as those defined in commonly used dictionaries, should be interpreted as having a meaning that is consistent with their meaning in the context of the related art and will not be interpreted in an idealized or overly formal sense unless expressly so defined herein.

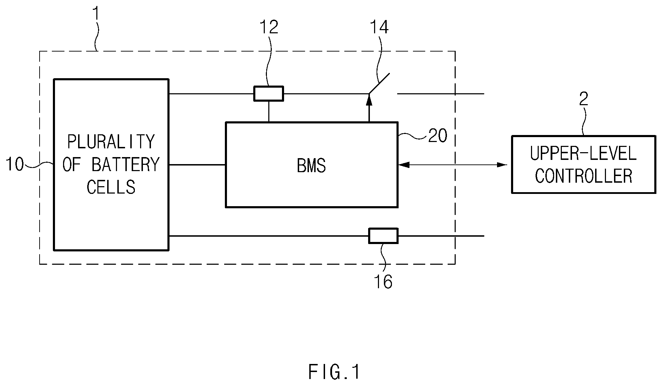

FIG. 1 is a block diagram showing a configuration of a general battery pack.

Referring to FIG. 1, a battery control system including a battery pack 1 according to an embodiment of the present invention and an upper-level controller 2 included in an upper-level system is schematically illustrated.

As illustrated in FIG. 1, the battery pack 1 may be made of one or more battery cells, and may include a plurality of rechargeable battery cells 10, a switching unit 14 for controlling charge and discharge current flow of the plurality of battery cells 10 by being connected to a positive (+) terminal or a negative (-) terminal of the plurality of battery cells 10 in series, and a battery management system 20 for performing control and management to prevent overcharge, overdischarge, and the like by monitoring voltage, current, temperature, or the like of the battery pack 1. In this case, a plurality of battery packs 1 equipped with a plurality of battery cells 10, a sensor 12, a switching unit 14, and a battery management system 20 may be provided.

Here, the switching unit 14 is a device for controlling the current flow for charging or discharging of the plurality of battery cells 10, and for example, at least one relay, magnetic contactor, or the like, may be used depending on the specifications of the battery pack 1.

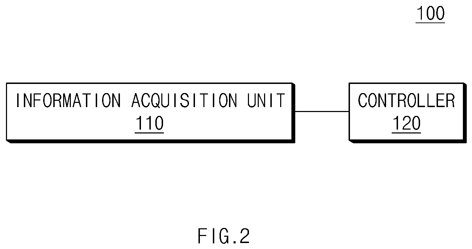

The battery management system 20 may be an interface for receiving values obtained by measuring the above-mentioned various parameters, and may include a plurality of terminals, a circuit connected to the terminals to process input values, or the like. In addition, the battery management system 20 may control the ON/OFF of the switching unit 14, for example, a relay, a contactor, or the like, and may be connected to the plurality of battery cells 10 to monitor the state of each of the plurality of battery cells 10. According to the embodiment, the battery management system 20 may include a battery diagnostic device 100 in FIG. 2. In another embodiment, the battery management system 20 may be a different system than the battery diagnostic device 100 in FIG. 2. That is, the battery diagnostic device 100 of FIG. 2 may be included in the battery pack 1 or may be configured as another device external to the battery pack 1. In addition, the operation of the battery diagnostic device 100 below may be performed by a battery management system (BMS) in the vehicle, as well as by various devices such as a server, a cloud, a charger, or a charger/discharger.

The upper-level controller 2 may transmit a control signal for the plurality of battery cells 10 to the battery management system 20. Accordingly, the battery management system 20 may be controlled based on the signal received from the upper-level controller 2.

FIG. 2 is a diagram showing a battery diagnostic device according to an embodiment disclosed herein.

The battery diagnostic device 100 may be various electronic devices for diagnosing or testing a battery. For example, the battery diagnostic device 100 may be included in a battery management system (BMS) within a vehicle, but may also be implemented as a separate external device distinct from the BMS within the vehicle.

According to another embodiment, the battery diagnostic device 100 may be included in a device for charge/discharge testing, such as a server, a cloud server, or a charge/discharge cycler, or may be included in various devices for diagnosing or testing a battery.

Referring to FIG. 2, the battery diagnostic device 100 may include an information acquisition unit 110 and a controller 120.

The information acquisition unit 110 may acquire voltages of a plurality of battery cells. According to the embodiment, the information acquisition unit 110 may acquire an open circuit voltage of each of the plurality of battery cells. According to another embodiment, the information acquisition unit 110 may acquire the voltage and accumulated current of each of the plurality of battery cells at each specific voltage increase section when charging the plurality of battery cells. According to still another embodiment, the information acquisition unit 110 may acquire the voltage and accumulated current of each of the plurality of battery cells at each specific voltage reduction section when discharging the plurality of battery cells. According to the embodiment, the information acquisition unit 110 may further acquire the temperature of each of the plurality of battery cells.

The controller 120 may calculate a capacity/voltage second-order differential value of the voltages of the plurality of battery cells. For example, the capacity/voltage second-order differential value may include either a second-order differential value of the capacity with respect to voltage or a second-order differential value of the voltage with respect to the capacity. For another example, the controller 120 may calculate the capacity/voltage second-order differential value of the voltages of the plurality of battery cells that are being charged or discharged.

According to the embodiment, the controller 120 may calculate a capacity/voltage differential value (dQ/dV) with respect to the voltages of the plurality of battery cells that are being charged or discharged, and may calculate a capacity/voltage second-order differential value (d2Q/dV2) based on the capacity/voltage differential value (dQ/dV).

According to another embodiment, the controller 120 may calculate a capacity/voltage differential value (dV/dQ) with respect to the voltages of the plurality of battery cells that are being charged or discharged, and may calculate a capacity/voltage second-order differential value (d2V/dQ2) based on the capacity/voltage differential value (dV/dQ).

According to the embodiment, the controller 120 may calculate the capacity/voltage second-order differential value of each of the plurality of battery cells. According to another embodiment, the controller 120 may calculate the capacity/voltage second-order differential value of an average of the voltages of each of the plurality of battery cells.

The controller 120 may set at least a portion of the SOC section or at least a portion of the voltage section in which the second-order differential value is less than or equal to a first value as a diagnostic section. For example, when a section where the second-order differential value (d2V/dQ2) is less than or equal to the first value is from SOC 60 to SOC 80, the controller 120 may set a portion of the section from SOC 60 to SOC 80 as the diagnostic section. For another example, when a voltage section where the second-order differential value (d2Q/dV2) is less than or equal to the first value is from 3.8 V to 4.1 V, the controller 120 may set a portion of the section from 3.8 V to 4.1 V as the diagnostic section.

According to the embodiment, the first value may be set to 0.1, or the like, but is not limited thereto, and the first value may be set to specify a section in which a change in the capacity/voltage differential value is smaller than a set value.

According to the embodiment, the controller 120 may calculate the capacity/voltage second-order differential value for each of the plurality of battery cells. In addition, the controller 120 may set a portion of the SOC section in which the second-order differential values of all of the plurality of battery cells are less than or equal to the first value as the diagnostic section. For example, the controller 120 may check a section in which the capacity/voltage second-order differential value of each of the plurality of battery cells is less than or equal to the first value, and set the overlapping section as the diagnostic section.

According to the embodiment, the controller 120 may calculate an average voltage of the plurality of battery cells. In addition, the controller 120 may calculate the capacity/voltage second-order differential value with respect to the average voltage of the plurality of battery cells, and may set a portion of the SOC section or voltage section in which the capacity/voltage second-order differential value with respect to the average voltage of the plurality of battery cells is less than or equal to the first value as the diagnostic section.

That is, the controller 120 may set a specific SOC section as the diagnostic section based on a value obtained by quadratically differentiating the voltages of the plurality of battery cells with respect to the capacities, or set a specific voltage section as the diagnostic section based on a value obtained by quadratically differentiating the capacities of the plurality of battery cells with respect to the voltages.

The controller 120 may diagnose the plurality of battery cells in the diagnostic section. For example, the controller 120 may diagnose each of the plurality of battery cells in the diagnostic section.

According to the embodiment, the controller 120 may calculate a partial capacity of each of the plurality of battery cells in the diagnostic section. In addition, the controller 120 may diagnose the plurality of battery cells based on the calculated partial capacity of each of the plurality of battery cells. For example, the controller 120 may calculate the partial capacity of each of the plurality of battery cells through current accumulation. According to the embodiment, a current value required for current accumulation may be acquired from the information acquisition unit 110. For another example, the controller 120 may calculate a deviation of the partial capacity of each of the plurality of battery cells, and determine a battery cell with a deviation equal to or greater than a second value as an abnormal battery cell.

According to the embodiment, the controller 120 may calculate an average of the partial capacities of each of the plurality of battery cells, and may calculate a difference between the average of the partial capacities of each of the plurality of battery cells and the partial capacity of each of the plurality of battery cells. In this case, the controller 120 may determine a battery cell with a difference equal to or greater than a set value as the abnormal battery cell. For another example, the controller 120 may calculate a standard deviation of the partial capacity of each of the plurality of battery cells according to a normal distribution based on the average of the partial capacities of each of the plurality of battery cells, and may determine a battery cell with a standard deviation equal to or greater than a threshold value as the abnormal battery cell.

According to the embodiment, the controller 120 may diagnose a battery cell in which the deviation of the partial capacity of each of the plurality of battery cells is equal to or greater than the second value as a battery in which lithium precipitation or tab breakage has occurred.

The battery diagnostic device 100 according to an embodiment disclosed herein may diagnose partial capacity reduction and lithium precipitation of a battery cell based on a battery diagnostic technology utilizing differentiation.

The battery diagnostic device 100 according to an embodiment disclosed herein may diagnose a battery cell or a battery pack based on field data of a battery.

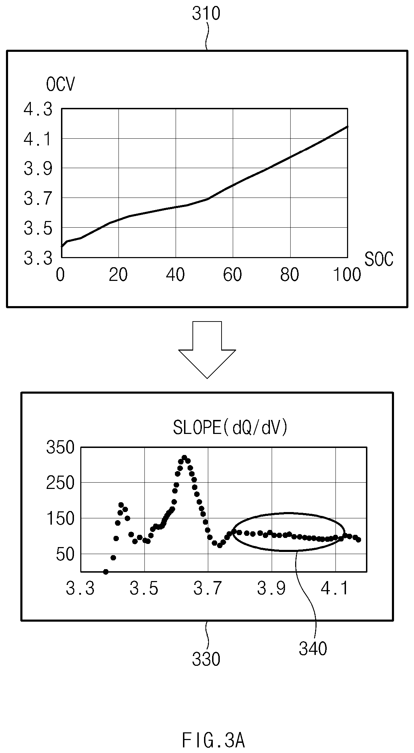

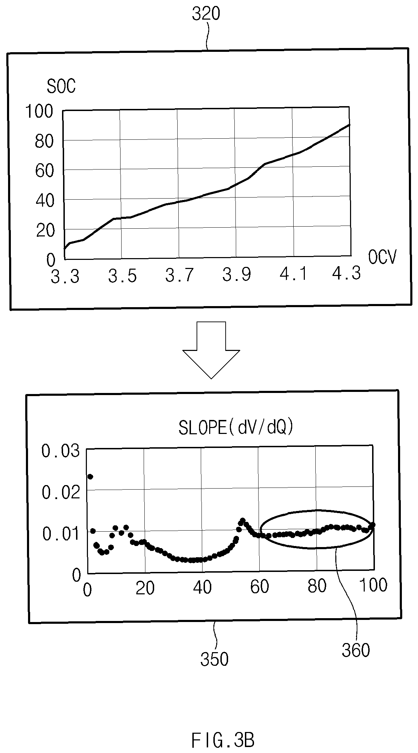

FIGS. 3a and 3b are views showing an example in which the battery diagnostic device sets a diagnostic section according to an embodiment disclosed herein.

Referring to FIGS. 3a and 3b, the information acquisition unit 110 of the battery diagnostic device 100 according to an embodiment disclosed herein may acquire voltages 310 and 320 of each of a plurality of battery cells. For example, the information acquisition unit 110 may acquire the voltage corresponding to the SOC of each of a plurality of battery cells that are being charged or discharged or the SOC corresponding to the voltage.

The controller 120 of the battery diagnostic device 100 according to an embodiment disclosed herein may calculate a voltage/capacity differential value based on the voltage 310 corresponding to the SOC of each of the plurality of battery cells or the SOC 320 corresponding to the voltage. For example, the controller 120 may calculate a voltage/capacity differential value (dQ/dV) 330 based on the voltage 310 corresponding to the SOC of each of the plurality of battery cells. For another example, the controller 120 may calculate a voltage/capacity differential value (dV/dQ) 350 based on the SOC 320 corresponding to the voltage of each of the plurality of battery cells.

According to the embodiment, the controller 120 may calculate a second-order differential value of the voltage/capacity differential value (dQ/dV) 330 and set at least a portion of a voltage section 340 in which the second-order differential value is less than or equal to a first value as a diagnostic section.

According to another embodiment, the controller 120 may calculate a second-order differential value of the voltage/capacity differential value (dV/dQ) 350 and set at least a portion of the SOC section 360 in which the second-order differential value is less than or equal to the first value as the diagnostic section.

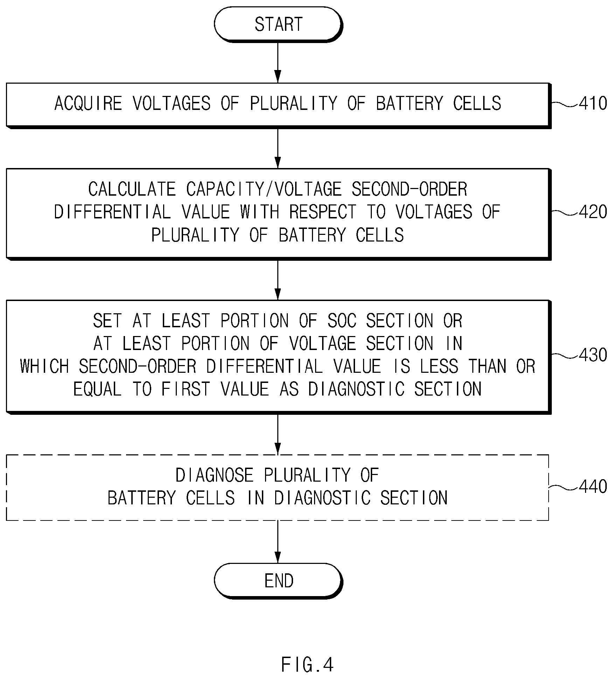

FIG. 4 is a flowchart showing a method of operating a battery diagnostic device according to an embodiment disclosed herein. According to the embodiment, the operations shown in FIG. 4 may be performed through the battery diagnostic device 100 in FIG. 2.

Referring to FIG. 4, in operation 410, the information acquisition unit 110 may acquire voltages of a plurality of battery cells. According to the embodiment, the information acquisition unit 110 may acquire the open circuit voltage of each of the plurality of battery cells. According to another embodiment, the information acquisition unit 110 may acquire the voltage and accumulated current of each of the plurality of battery cells at each specific voltage increase section when charging the plurality of battery cells. According to still another embodiment, the information acquisition unit 110 may acquire the voltage and accumulated current of each of the plurality of battery cells at each specific voltage reduction section when discharging the plurality of battery cells. According to the embodiment, the information acquisition unit 110 may further acquire the temperature of each of the plurality of battery cells.

In operation 420, the controller 120 may calculate a capacity/voltage second-order differential value of the voltage of the plurality of battery cells. For example, the capacity/voltage second-order differential value may include either a second-order differential value of the capacity with respect to voltage or a second-order differential value of the voltage with respect to the capacity. For another example, the controller 120 may calculate the capacity/voltage second-order differential value of the voltages of the plurality of battery cells that are being charged or discharged.

According to the embodiment, the controller 120 may calculate a capacity/voltage differential value (dQ/dV) with respect to the voltages of the plurality of battery cells that are being charged or discharged, and may calculate a capacity/voltage second-order differential value (d2Q/dV2) based on the capacity/voltage differential value (dQ/dV).

According to another embodiment, the controller 120 may calculate a capacity/voltage differential value (dV/dQ) with respect to the voltages of the plurality of battery cells that are being charged or discharged, and may calculate a capacity/voltage second-order differential value (d2V/dQ2) based on the capacity/voltage differential value (dV/dQ).

According to the embodiment, the controller 120 may calculate the capacity/voltage second-order differential value of each of the plurality of battery cells. According to another embodiment, the controller 120 may calculate the capacity/voltage second-order differential value of an average of the voltages of each of the plurality of battery cells.

In operation 430, the controller 120 may set at least a portion of an SOC section or at least a portion of a voltage section in which the second-order differential value is less than or equal to a first value as a diagnostic section. For example, when a section where the second-order differential value (d2V/dQ2) is less than or equal to the first value is from SOC 60 to SOC 80, the controller 120 may set a portion of the section from SOC 60 to SOC 80 as the diagnostic section. For another example, when a voltage section where the second-order differential value (d2Q/dV2) is less than or equal to the first value is from 3.8 V to 4.1 V, the controller 120 may set a portion of the section from 3.8 V to 4.1 V as the diagnostic section.

According to the embodiment, the first value may be set to 0.1, or the like, but is not limited thereto, and the first value may be set to specify a section in which a change in the capacity/voltage differential value is smaller than a set value.

According to the embodiment, the controller 120 may calculate the capacity/voltage second-order differential value for each of the plurality of battery cells. In addition, the controller 120 may set a portion of the SOC section in which the second-order differential values of all of the plurality of battery cells are less than or equal to the first value as the diagnostic section. For example, the controller 120 may check a section in which the capacity/voltage second-order differential value of each of the plurality of battery cells is less than or equal to the first value, and set the overlapping section as the diagnostic section.

According to the embodiment, the controller 120 may calculate an average voltage of the plurality of battery cells. In addition, the controller 120 may calculate the capacity/voltage second-order differential value with respect to the average voltage of the plurality of battery cells, and may set a portion of the SOC section or voltage section in which the capacity/voltage second-order differential value with respect to the average voltage of the plurality of battery cells is less than or equal to the first value as the diagnostic section.

That is, the controller 120 may set a specific SOC section as the diagnostic section based on a value obtained by quadratically differentiating the voltages of the plurality of battery cells with respect to the capacities, or set a specific voltage section as the diagnostic section based on a value obtained by quadratically differentiating the capacities of the plurality of battery cells with respect to the voltages.

In operation 440, the controller 120 may diagnose the plurality of battery cells in the diagnostic section. For example, the controller 120 may diagnose each of the plurality of battery cells in the diagnostic section.

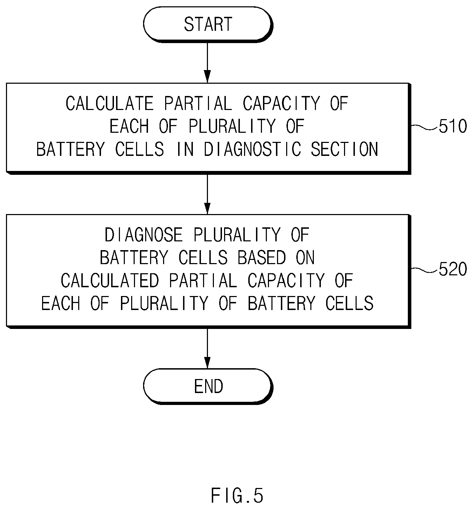

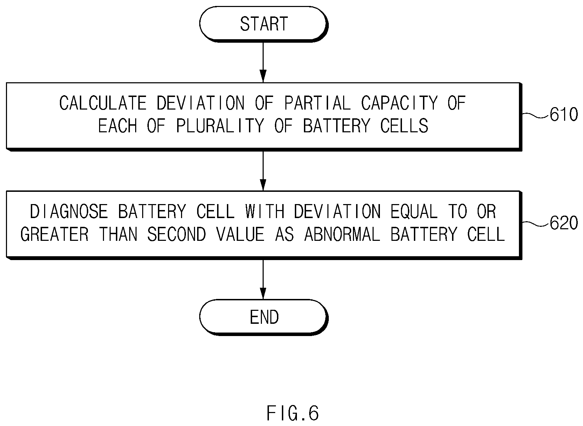

FIGS. 5 and 6 are flowcharts specifically showing an operating method of a battery diagnostic device according to an embodiment disclosed herein.

Referring to FIG. 5, in operation 510, the controller 120 may calculate a partial capacity of each of the plurality of battery cells in the diagnostic section. For example, the controller 120 may calculate the partial capacity of each of the plurality of battery cells through current accumulation. According to the embodiment, a current value required for current accumulation may be acquired from the information acquisition unit 110.

In operation 520, the controller 120 may diagnose the plurality of battery cells based on the calculated partial capacity of each of the plurality of battery cells.

Referring to FIG. 6, in operation 610, the controller 120 may calculate a deviation of the partial capacity of each of the plurality of battery cells.

In operation 620, the controller 120 may diagnose a battery cell with a deviation equal to or greater than a second value as an abnormal battery cell.

According to the embodiment, the controller 120 may calculate an average of the partial capacities of each of the plurality of battery cells, and may calculate a difference between the average of the partial capacities of each of the plurality of battery cells and the partial capacity of each of the plurality of battery cells. In this case, the controller 120 may determine a battery cell with a difference equal to or greater than a set value as the abnormal battery cell. For another example, the controller 120 may calculate a standard deviation of the partial capacity of each of the plurality of battery cells according to a normal distribution based on the average of the partial capacities of each of the plurality of battery cells, and may determine a battery cell with a standard deviation equal to or greater than a threshold value as the abnormal battery cell.

According to the embodiment, the controller 120 may diagnose a battery cell in which the deviation of the partial capacity of each of the plurality of battery cells is equal to or greater than the second value as a battery in which lithium precipitation or tab breakage has occurred.

According to the embodiment, operations 610 and 620 may be performed as included in operation 520 in FIG. 5.

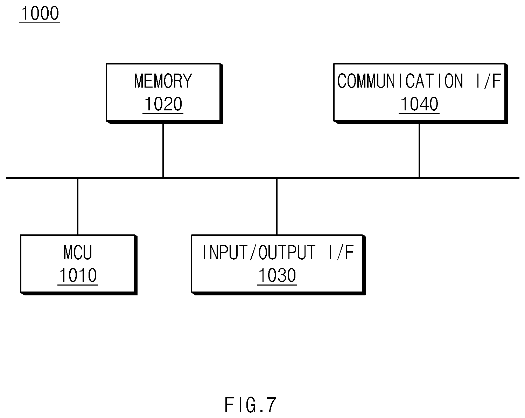

FIG. 7 is a block diagram showing a hardware configuration of a computing system for performing a method of operating a battery diagnostic device according to an embodiment disclosed herein.

Referring to FIG. 7, a computing system 1000 according to an embodiment disclosed herein may include a microcontroller unit (MCU) 1010, a memory 1020, an input/output interface I/F 1030, and a communication I/F 1040.

The MCU 1010 may be a processor that executes various programs stored in the memory 1020 (e.g., a program for measuring voltages of a plurality of battery cells, a program for calculating capacity/voltage second-order differential values of the plurality of battery cells, a program for setting a diagnostic section for the plurality of battery cells, a program for calculating a partial capacity and a deviation of the diagnostic section for the plurality of battery cells, and the like), processes various information including voltages of the plurality of battery cells, capacity/voltage second-order differential values of the plurality of battery cells, the diagnostic section for the plurality of battery cells, a partial capacity and deviation of the diagnostic section for the plurality of battery cells, a diagnosis result of the plurality of battery cells, and the like, through the programs, and performs functions of the controller included in the battery diagnostic device shown in FIG. 2 described above.

The memory 1020 may store various programs, such as the program for measuring voltages of the plurality of battery cells, the program for calculating capacity/voltage second-order differential values of the plurality of battery cells, the program for setting the diagnostic section for the plurality of battery cells, the program for calculating the partial capacity and a deviation of the diagnostic section for the plurality of battery cells, and the like. In addition, the memory 1020 may store various information including voltages of the plurality of battery cells, capacity/voltage second-order differential values of the plurality of battery cells, the diagnostic section for the plurality of battery cells, the partial capacity and deviation of the diagnostic section for the plurality of battery cells, the diagnostic result of the plurality of battery cells, and the like.

A plurality of memories 1020 may be provided as needed. The memory 1020 may be a volatile memory or a non-volatile memory. As the volatile memory, the memory 1020 may be a random-access memory (RAM), a dynamic RAM (DRAM), a static RAM (SRAM), or the like. As the non-volatile memory, the memory 1020 may be a read-only memory (ROM), a programmable ROM (PROM), an electrically alterable ROM (EAROM), an erasable programmable ROM (EPROM), an electrically erasable programmable ROM (EEPROM,) a flash memory, or the like. The examples of memories 1020 listed above are only exemplary and are not limited to the examples.

The input/output I/F 1030 may provide an interface that connects an input device (not shown) such as a keyboard, mouse, touch panel, or the like, and an output device such as a display (not shown), to the MCU 1010 to enable data transmission and reception.

The communication I/F 1040 is a component that may transmit and receive various data to and from the server, and may be any device that may support wired or wireless communication. For example, the battery diagnostic device may transmit and receive various information including voltages of the plurality of battery cells, capacity/voltage second-order differential values of the plurality of battery cells, the diagnostic section for the plurality of battery cells, the partial capacity and deviation of the diagnostic section for the plurality of battery cells, the diagnostic result of the plurality of battery cells, and the like, to and from a separately provided external server through the communication I/F 1040.

By being recorded in the memory 1020 and processed by the MCU 1010 in this way, a computer program according to an embodiment disclosed herein may be implemented, for example, as a module that performs each of the functions shown in FIG. 2.

The above description is merely an example of the technical idea disclosed herein, and those with ordinary skill in the art to which the embodiments disclosed herein belong may make various modifications and variations without departing from the essential characteristics of the embodiments disclosed herein.

Accordingly, the embodiments disclosed herein are not intended to limit the technical ideas disclosed herein but rather to explain them, and the scope of the technical ideas disclosed herein is not limited by these embodiments. The scope of protection disclosed herein should be interpreted by the accompanying claims, and all technical ideas within the scope equivalent thereto should be construed as being included in the scope of rights herein.

## Claims

1. A battery diagnostic device comprising:
an information acquisition unit configured to acquire voltages of a plurality of battery cells; and
a controller configured to:
calculate a capacity/voltage second-order differential value of the voltages of the plurality of battery cells; and
set at least a portion of a state of charge (SOC) section or at least a portion of a voltage section in which the second-order differential value is less than or equal to a first value as a diagnostic section.

2. The battery diagnostic device of claim 1, wherein the controller diagnoses the plurality of battery cells in the diagnostic section.

3. The battery diagnostic device of claim 1, wherein the controller:
calculates a partial capacity of each of the plurality of battery cells in the diagnostic section; and
diagnoses the plurality of battery cells based on the calculated partial capacity of each of the plurality of battery cells.

4. The battery diagnostic device of claim 3, wherein the controller calculates the partial capacity of each of the plurality of battery cells through current accumulation.

5. The battery diagnostic device of claim 3, wherein the controller:
calculates a deviation of the partial capacity of each of the plurality of battery cells; and
diagnoses a battery cell with a deviation equal to or greater than a second value as an abnormal battery cell.

6. The battery diagnostic device of claim 1, wherein the controller:
calculates the capacity/voltage second-order differential value for each of the plurality of battery cells; and
sets at least a portion of the SOC section or at least a portion of the voltage section in which second-order differential values of all of the plurality of battery cells are less than or equal to the first value as the diagnostic section.

7. The battery diagnostic device of claim 1, wherein the controller:
calculates an average voltage of the plurality of battery cells;
calculates a capacity/voltage second-order differential value with respect to the average voltage of the plurality of battery cells; and
sets at least a portion of the SOC section or at least a portion of the voltage section in which the capacity/voltage second-order differential value with respect to the average voltage of the plurality of battery cells is less than or equal to the first value as the diagnostic section.

8. The battery diagnostic device in claim 1, wherein the voltages of the plurality of battery cells are open circuit voltages of the plurality of battery cells.

9. A method of operating a battery diagnostic device, comprising:
acquiring voltages of a plurality of battery cells;
calculating a capacity/voltage second-order differential value of the voltages of the plurality of battery cells; and
setting at least a portion of a state of charge (SOC) section or at least a portion of a voltage section in which the second-order differential value is less than or equal to a first value as a diagnostic section.

10. The method of claim 9, further comprising diagnosing the plurality of battery cells in the diagnostic section.

11. The method of claim 9, further comprising:
calculating a partial capacity of each of the plurality of battery cells in the diagnostic section; and
diagnosing the plurality of battery cells based on the calculated partial capacity of each of the plurality of battery cells.

12. The method of claim 11, wherein in the calculating of the partial capacity of each of the plurality of battery cells in the diagnostic section, the partial capacity of each of the plurality of battery cells is calculated through current accumulation.

13. The method of claim 11, wherein the diagnosing of the plurality of battery cells based on the calculated partial capacity of each of the plurality of battery cells includes:
calculating a deviation of the partial capacity of each of the plurality of battery cells; and
diagnosing a battery cell with a deviation equal to or greater than a second value as an abnormal battery cell.
